# EUROPEAN PATENT APPLICATION

(11) **EP 1 727 391 A1**
(43) Date of publication of application: **29.11.2006**
(21) Application number: 05720245.9
(22) Date of filing: 08.03.2005
(51) Int. Cl.: H04R 3/00, H03G 3/02, H04S 1/00

(54) **VOLUME CONTROL METHOD, VOLUME CONTROLLER, VOLUME CONTROL PROGRAM, ELECTRONIC APPARATUS**

(30) Priority: 19.03.2004 JP 2004080560
(71) Applicant: Pioneer Corporation, Tokyo 153-8654 (JP)
(72) Inventor: IKAWA, Motohiro Pioneer Corporation Kawagoe Works, Kawagoe-shi Saitama 350-8555 (JP)
(74) Representative: HOFFMANN EITLE
(86) International application number: PCT/JP2005/003973
(87) International publication number: WO 2005/091671

(57) **Abstract**

A sound-volume controlling method of controlling sound volume per step to achieve a more accurate sound volume control as desired by a user by using step zones effectively, includes a changing step for changing a volume change amount per step, and a controlling step for controlling sound volume based on changed volume change amount per step. A sound-volume controller for controlling sound volume per step includes a changing unit that changes a volume change amount per step, and a controlling unit that controls sound volume based on changed volume change amount per step.

## Description

### TECHNICAL FIELD

The present invention relates to a sound-volume controlling method, a sound-volume controller, a sound-volume controlling computer program, and electronic equipment for controlling sound volume of audio products.

### BACKGROUND ART

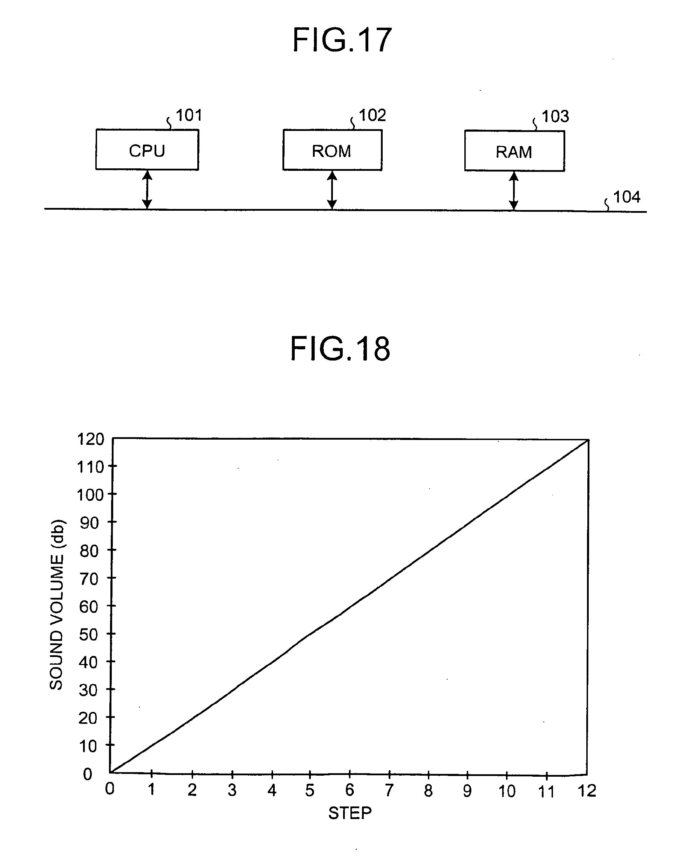

Recently, so-called electronic volume control is widely used for adjusting sound volume of electronic equipment having a sound output mechanism, for example, a notebook computer, a portable music player, or an audio device. By electronic volume control, sound volume is adjusted by changing a volume change amount determined for each step, as shown on a graph for explaining relation between sound-volume control steps and sound output volume in Fig. 18. One approach for controlling sound volume by using electronic volume is to divide the entire control zone of sound volume into two zones, and sound volume is successively increased in a high sound-volume zone to reduce a sound-volume changing speed in the high sound-volume zone smaller than a sound volume changing speed in a low sound-volume zone (for example, see Patent Document 1). Based on such technology for controlling sound volume, the volume-control range is equally divided, and a volume change amount for each divided volume-control range is set uniform. Thus, sound volume is controlled.

Patent Document: Japanese Patent Application Laid-open No. H11-68484

### DISCLOSURE OF INVENTION

### PROBLEM TO BE SOLVED BY THE INVENTION

Even if 15 steps of electronic volume control are provided in a sound-volume controlling device, an individual user uses more or less three to four steps to usually listen to music or the like. In other words, despite that a large number of steps for controlling sound volume are generally provided in a sound-volume controlling device, the number of steps used by an individual user is limited to specific steps, and the steps are not effectively used.

On the other hand, although a change amount of sound volume per step varies depending on a setting in each device, the number of steps to be set is limited and a certain maximum range of sound volume has to be adjusted with a predetermined number of steps. Consequently, a fine adjustment of sound volume desired by a user cannot be achieved.

Precisely, problems that the present invention is to solve include, for example, that, in the conventional technology described above, steps are not effectively used, and a fine adjustment of sound volume desired by a user is not be achieved.

It is therefore an object of the present to obtain a sound-volume controlling method, a sound-volume controller, a computer program capable of more accurate and precise adjustment of sound volume using step zones effectively according to users' individual needs, and electronic equipment.

### MEANS FOR SOLVING PROBLEM

According to claim 1, a sound-volume controlling method of controlling sound volume per step, includes a changing step for changing a volume change amount per step, and a controlling step for controlling sound volume based on changed volume change amount per step.

According to claim 2, a sound-volume controlling method of controlling sound volume per step, includes a zone specifying step for specifying a step zone in which a volume change amount per step is to be changed, a changing step for changing a volume change amount per step in specified step zone, and a controlling step for controlling sound volume based on changed volume change amount per step.

According to claim 7, a sound-volume controller that controls sound volume per step, includes a changing unit that changes a volume change amount per step, and a controlling unit that controls sound volume based on changed volume change amount per step.

According to claim 8, a sound-volume controller that controls sound volume per step, includes a zone specifying unit that specifies a step zone in which a volume change amount per step is to be changed, a changing unit that changes a volume change amount per step in specified step zone, and a controlling unit that controls sound volume based on changed volume change amount per step.

According to claim 10, electronic equipment includes the sound-volume controller according to any one of claims 7 to 9.

According to claim 11, a computer program for controlling sound volume that causes a computer to execute a method of controlling sound volume per step, causes the computer to execute a changing step for changing a volume change amount per step, and a controlling step for controlling sound volume based on changed volume change amount per step.

### BRIEF DESCRIPTION OF DRAWINGS

[Fig. 1] Fig. 1 is a graph for explaining relation between sound-volume control steps and sound output volume in a default mode;
[Fig. 2] Fig. 2 is a graph for explaining relation between the steps and sound output volume when a volume change rate in a certain step zone is changed by a sound-volume controlling method according to the present invention;
[Fig. 3] Fig. 3 is a block diagram of relevant units of a sound-volume controller;
[Fig. 4] Fig. 4 is a graph for explaining relation between the steps and sound output volume under the default mode; [Fig. 5] Fig. 5 is a graph for explaining relation between the steps and sound output volume when a volume change rate in a certain step zone is changed by a sound-volume controlling method according to the present invention;
[Fig. 6] Fig. 6 is a flowchart of a process for controlling sound volume output from an audio device by using the sound-volume controller;
[Fig. 7] Fig. 7 is a graph for explaining relation between the steps and sound output volume under the default mode;
[Fig. 8] Fig. 8 is a graph for explaining relation between the steps and sound output volume when a volume change rate in a certain step zone is changed by a sound-volume controlling method according to the present invention;
[Fig. 9] Fig. 9 is a graph for explaining relation between the steps and sound output volume under the default mode;
[Fig. 10] Fig. 10 is a graph for explaining relation between the steps and sound output volume when a volume change rate in a certain step zone is changed by a sound-volume controlling method according to the present invention;
[Fig. 11] Fig. 11 is a graph for explaining relation between the steps and sound output volume under the default mode;
[Fig. 12] Fig. 12 is a graph for explaining relation between the steps and sound output volume when a volume change rate in step zone is changed by the sound-volume controlling method according to the present invention;
[Fig. 13] Fig. 13 is a graph for explaining relation between the steps and sound output volume under the default mode;
[Fig. 14] Fig. 14 is a graph for explaining relation between the steps and sound output volume when a volume change rate in an certain step zone is changed by a sound-volume controlling method according to the present invention;
[Fig. 15] Fig. 15 is a graph for explaining relation between the steps and sound output volume in a rough adjustment mode;
[Fig. 16] Fig. 16 is a graph for explaining relation between the steps and sound output volume in a fine adjustment mode;
[Fig. 17] Fig. 17 is a diagram of relevant part of hardware (computer) that execute a computer program for controlling sound volume; and [Fig. 18] Fig. 18 is a graph for explaining relation between sound-volume control steps and sound output volume under a general setting condition of a volume change rate according to a conventional technology.

### EXPLANATIONS OF LETTERS OR NUMERALS

- 10: Input unit
- 12: Determining-and-controlling unit
- 14: Storage unit
- 16: Fine-adjustment setting unit
- 18: Rough-adjustment setting unit
- 20: Step detecting unit

### BEST MODE(S) FOR CARRYING OUT THE INVENTION

A sound-volume controlling method, a sound-volume controller, a sound-volume controlling computer program, and electronic equipment according to exemplary embodiments of the present invention is explained below in detail with reference to the drawings. The present invention is not limited by the following description, and can be changed or modified in various manners as required without departing from the scope of the present invention.

### [Mode for Carrying Out the Invention]

First, a basic concept of a sound-volume controlling method according to an embodiment of the present invention is explained. The sound-volume controlling method according to the present invention is a technology related to electronic volume used for controlling sound volume of electronic equipment having a sound output mechanism, such as an audio device.

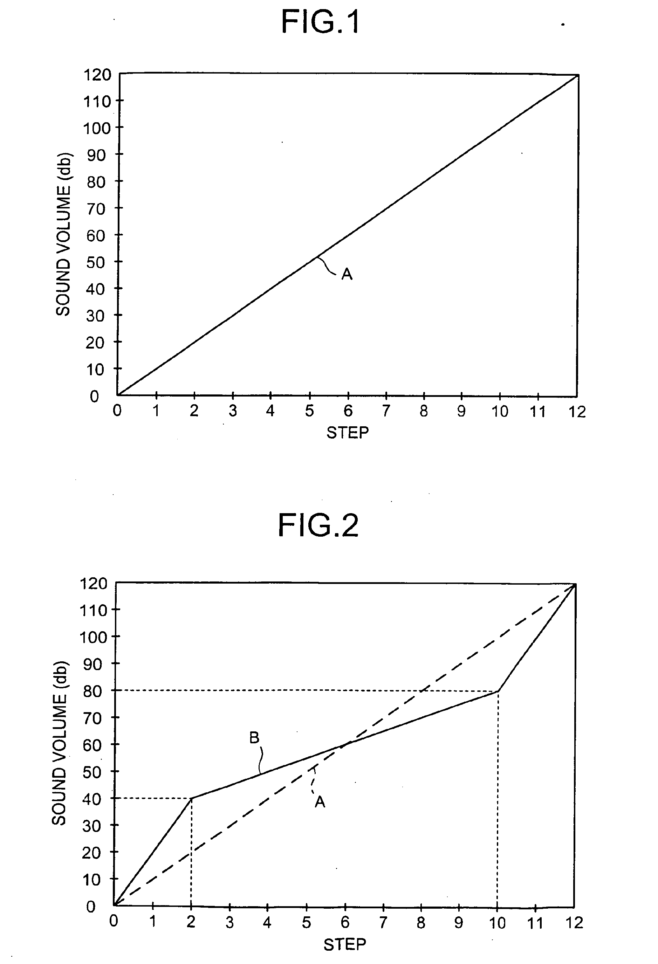

Fig. 1 is a graph for explaining relation between sound-volume control steps (hereinafter, "step") and sound output volume in a default mode. A case where sound output volume from 0 dB to 120 dB is controlled by using a step zone ranging from step 0 to step 12 is explained below as an example. A characteristic curve A shown on the graph in Fig. 1 that indicates relation between the steps and sound output volume has, for convenience, a constant slope in the entire step zone so that sound output volume is proportional to the steps. Here, the slope of the characteristic curve A indicates a volume change amount per step. Hereinafter, a volume change amount per step is, for convenience, referred to as a volume change rate. A volume change rate of the characteristic curve A is 10 dB/step.

Fig. 2 is a graph for explaining relation between the steps and sound output volume when a volume change rate is changed in a certain step zone by the sound-volume controlling method according to the present invention. According to the present invention, by setting a small volume change rate, a finer adjustment for controlling sound volume is achieved. On a characteristic curve B shown in Fig. 2 that indicates relation between the steps and sound output volume, its slope, precisely, a volume change amount per step, shifts at step 2 and step 10. On the characteristic curve B shown in Fig. 2, a volume change rate per step is 20 dB/step in a step zone between step 0 and step 2. In a step zone between step 2 and step 10, a volume change rate per step is 5 dB/step. In a step zone between step 10 and step 12, a volume change rate per step is 20 dB/step. In other words, the characteristic curve B shown in Fig. 2 has different volume change rates in respective step zones.

When sound output volume is controlled based on the volume change rate indicated by the characteristic curve A in Fig. 1 as described above, the sound output volume increases or decreases by 10 dB as a level or a value of a step is raised or lowered by one. Precisely, in this case, sound volume control is performed in unit of 10 dB, and this is in common over the entire step zone.

In contrast, when sound output volume is controlled based on the volume change rate indicated by the characteristic curve B in Fig. 2, in the step zone between step 0 and step 2, sound output volume increases or decreases by 20 dB as a level of a step is raised or lowered by one. In the step zone between step 2 and step 10, sound output volume increases or decreases by 5 dB as a level of a step is raised or lowered by one. In the step zone between step 10 and step 12, sound output volume increases or decreases by 20 dB as a level of a step is raised or lowered by one. Therefore, in this case, sound volume control is performed in unit of 20 dB in the step zone between step 0 and step 2, in unit of 5 dB in the step zone between step 2 and step 10, and in unit of 20 dB in the step zone between step 10 and step 12.

As described above, when sound output volume is controlled based on the volume change rates indicated by the characteristic curve B in Fig. 2, the volume change rate in the step zone between step 2 and step 10 is set smaller than that when sound output volume is controlled based on the volume change rate indicated by the characteristic curve A in Fig. 1. This enables a fine adjustment of sound volume in the step zone between step 2 and step 10. For example, when sound output volume is controlled based on the volume change rate indicated by the characteristic curve A in Fig. 1, sound volume in a range from 40 dB to 80 dB is controlled by using four steps from step 4 to step 8. However, when sound output volume is controlled based on the volume change rates indicated by the characteristic curve B in Fig. 2, sound volume in the range from 40 dB to 80 dB is controlled by using eight steps from step 2 to step 10. In this manner, a volume change rate in a specific step zone is set small to control sound volume in the specific step zone, which enables a finer adjustment of sound volume without increasing the number of steps and changing the maximum sound volume. Consequently, sound volume can be controlled more finely and more accurately as desired by a user. If, for example, a step zone that a user does not usually use is used for controlling sound volume in the specific step zone to increase the number of steps for controlling sound volume in the specific step zone, sound volume can be adjusted more precisely. This results in more accurate sound volume control by using step zones effectively.

Although the above description explains the case where, as shown in Fig. 1, the default mode has proportional relation between the steps and sound volume output by a sound output mechanism similarly to a conventional method for controlling sound volume, the present invention is not limited to this. For example, by storing a setting condition of a volume change rate set in the preceding time, the last setting condition can be applied to a default mode when the power is turned on again. For another example, default setting on power-up can be selectable between the initial setting and the preceding setting.

To sum up, the present invention has a basic concept that sound volume can be more accurately controlled by changing a volume change rate and using the range of steps effectively. The embodiments of the present invention are more fully explained below with concrete examples.

### [First Embodiment]

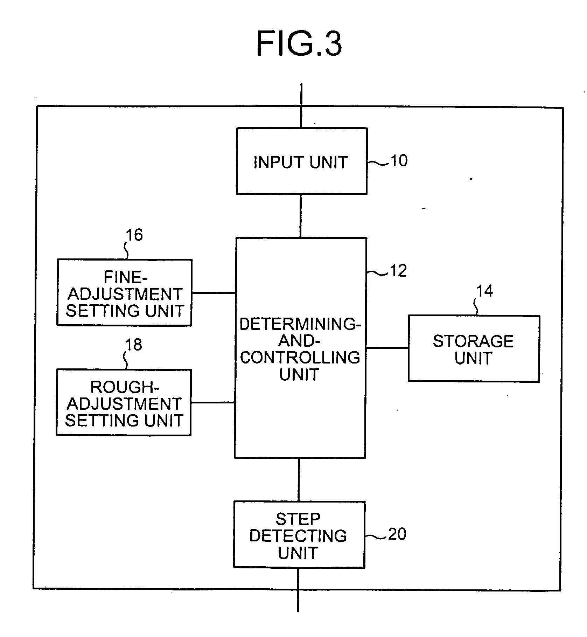

The example is explained as to the case where a sound-volume controller according to the present invention is applied to an audio device that is electronic equipment including a sound output mechanism. Fig. 3 is a block diagram of relevant units of a sound-volume controller 1 according to this embodiment. The sound-volume controller according to the present invention includes an input unit 10, a determining-and-controlling unit 12, a storage unit 14, a fine-adjustment setting unit 16, a rough-adjustment setting unit 18, and a step detecting unit 20.

The input unit 10 is a zone specifying unit that specifies a step zone in which a volume change rate is to be changed, and receives input of zone specification information for specifying a step zone in which a volume change rate is to be changed. Additionally, the input unit 10 receives input of information for instructing a fine adjustment mode or a rough adjustment mode. The determining-and-controlling unit 12 checks the zone specification information input to the input unit 10, calls setting pattern information of a volume change rate corresponding to the zone specification information from the storage unit 14, and provides the setting pattern information to the fine-adjustment setting unit 16 and the rough-adjustment setting unit 18 to change the volume change rate. The determining-and-controlling unit 12 also controls sound volume based on sound-volume control step information provided from the step detecting unit 20, which is described later, and a current setting condition of a volume change rate present in the storage unit, and creates an output sound signal. In addition, the determining-and-controlling unit 12 controls the entire sound-volume controller.

The storage unit 14 stores therein information about a setting pattern of a volume change rate associated with zone specification information to be input to the input unit. The storage unit 14 also stores therein a current setting condition of a volume change rate. The fine-adjustment setting unit 16 lowers a volume change rate in a specified step-zone based on information provided by the determining-and-controlling unit 12. The rough-adjustment setting unit 18 raises a volume change rate in a specified step zone based on information provided by the determining-and-controlling unit 12. The step detecting unit 20 detects a current setting of a sound-volume control step, and provides the current setting as sound-volume control step information to the determining-and-controlling unit 12.

This embodiment is explained on the assumption, for example, that the sound-volume controller 1 has 12 steps for controlling sound volume, and controls sound output volume from 0 dB to 120 dB by using the 12 steps. Other embodiments below are explained likewise.

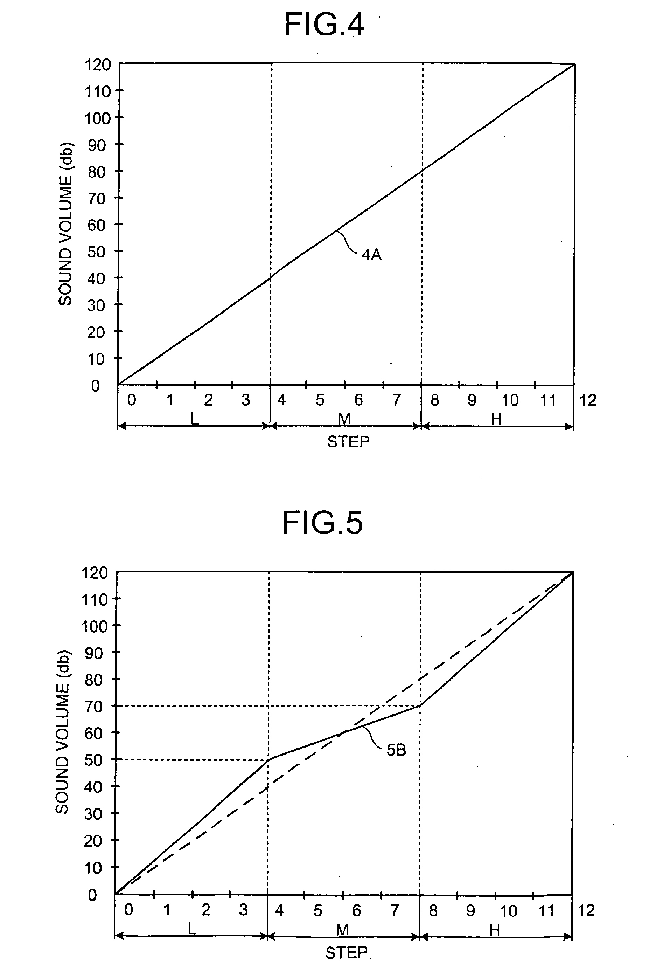

When the audio device is turned on, in the sound-volume controller 1 of the audio device, a volume change rate having a characteristic shown in Fig. 4 is set as an initial setting condition. Fig. 4 is a graph for explaining relation between the steps and sound output volume in a default mode. A slope of a characteristic curve 4A shown in Fig. 4 that represents the relation between the steps and sound output volume indicates a range of sound volume change per step, i.e., a volume change rate per step. The characteristic curve 4A has a constant slope over the entire step zone, so that sound output volume is proportional to the steps. The volume change rate of the characteristic curve 4A is 10 dB/step. When sound output volume is controlled based on this setting, the sound output volume increases or decreases by 10 dB as a level of a step is raised or lowered by one.

In the sound-volume controller 1, the entire step zone is divided into three step zones, namely, a zone L between step 0 and step 4, a zone M between step 4 and step 8, and a zone L between step 8 and step 12. The sound-volume controller 1 selects any one of the three step zones, and can set a volume change rate in selected step zone smaller than and different from a volume change rate in the other step zones.

For example, as shown with a characteristic curve 5B in Fig. 5, a volume change rate in the zone M, i.e., a step zone between step 4 and step 8, can be set smaller. On the characteristic curve 5B shown in Fig. 5, the volume change rate in the zone M is set at 5 dB/step. In this case, in the zone M, sound volume from 50 dB to 70 dB is controlled by using four steps from step 4 to step 8. According to the setting of the volume change rate shown in Fig. 4 (the characteristic curve 4A), as described above, the volume change rate is 10 dB/step. Accordingly, by lowering the volume change rate in the zone M to 5 dB/step as shown with the characteristic curve 5B in Fig. 5, the sound-volume controller 1 can achieve a fine adjustment of sound volume in the zone M compared to when the volume change rate is set as shown in Fig. 4 (the characteristic curve 4A). In other words, the sound-volume controller 1 can control sound volume finely and more accurately as desired by a user by using the step zones effectively.

On the other hand, in the zones L and H, a volume change rate is uniformly set to control sound volume in a range from 0 dB to 50 dB, and a range from 70 dB to 120 dB, with the remaining steps. Precisely, to control sound volume in the remaining ranges (the range from 0 dB to 50 dB, and the range from 70 dB to 120 dB) with remaining eight steps (steps other than the steps from step 4 to step 8), the volume change rate in the zones L and H is set larger than the volume change rate shown in Fig. 4 (the characteristic curve 4A). As shown with the characteristic curve 5B in Fig. 5, the volume change rate in this case is 12.5 dB/step.

Because the volume change rate in the zone L is set larger than the volume change rate shown in Fig. 4 (the characteristic curve 4A), a time needed for sound output volume to reach sound volume in the zone M from 0 dB is reduced. For example, to reach 50 dB of sound volume, a time corresponding to five steps is required on the setting of the volume change rate shown in Fig. 4 (the characteristic curve 4A). In contrast, on the setting of the volume change rates shown in Fig. 5 (the characteristic curve 5B), sound volume reaches 50 dB during a time corresponding to four steps. This can reduces a waiting time to reach desired sound volume, so that a user can control sound volume more comfortably.

Thus, the sound-volume controller 1 can control sound volume more finely by setting a smaller volume change rate in a specific step zone. Therefore, if a user desires to control sound volume in the zone M more finely, the user is only required to set a smaller volume change rate in the zone M. If a user desires to control sound volume in the zone L more finely, the user is only required to set a smaller volume change rate in the zone L.

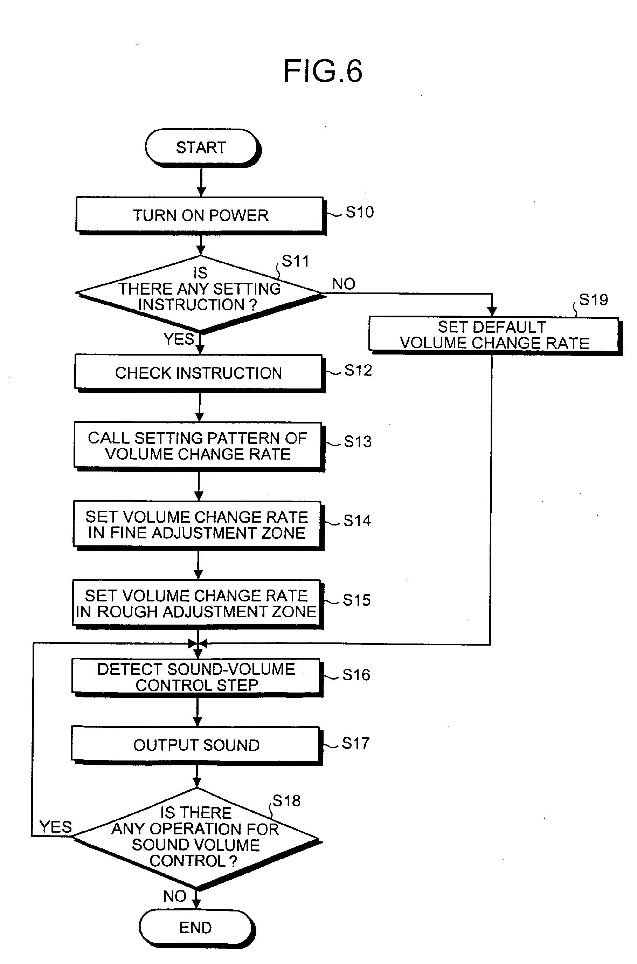

Next, operation of the sound-volume controller is explained with reference to Fig. 6. Fig. 6 is a flowchart of a process for controlling sound volume output from an audio device by using the sound-volume controller 1. To begin with, the audio device is turned on (step 10). The determining-and-controlling unit 12 determines whether the input unit 10 receives input of an instruction to set a volume change rate, precisely, zone specification information that specifies a step zone in which a volume change rate is to be changed (step 11).

If there is no instruction to set volume change rate (No at step 11), a volume change rate that is preset for a default mode is set (step 19). This volume change rate is the volume change rate indicated by the characteristic curve 4A in Fig. 4. Next, the step detecting unit 20 detects a current setting of a sound-volume control step, and provides the current setting as sound-volume control step information to the determining-and-controlling unit 12 (step 16).

The determining-and-controlling unit 12 then controls sound volume based on the sound-volume control step information provided from the step detecting unit 20 and a current setting condition of a volume change rate present in the storage unit 14, creates an output sound signal, and sends the output sound signal to a sound output device in the audio device. Thus, sound is output (step 17). Subsequently, the determining-and-controlling unit 12 determines whether sound volume control is operated by a user, i.e., a sound-volume control step is operated by the user (step 18). If there is no operation for sound volume control (No at step 18), the flow is ended. In contrast, if there is an operation for sound volume control (Yes at step 18), the process returns to step 16 again to be continued.

If there is an instruction to set a volume change rate (Yes at step 11), the determining-and-controlling unit 12 checks the zone specification information input to the input unit 10 (step 12), calls setting pattern information of a volume change rate corresponding to the zone specification information from the storage unit 14 (step 13), and provides the setting pattern information to the fine-adjustment setting unit 16 and the rough-adjustment setting unit 18.

Next, the fine-adjustment setting unit 16 changes a volume change rate to a lower value in a specified step zone (fine adjustment zone) based on information provided by the determining-and-controlling unit 12 (step 14). The rough-adjustment setting unit 18 changes a volume change rate to a larger value in a specified step zone (rough adjustment zone) based on information provided by the determining-and-controlling unit 12 (step 15). The storage unit 14 stores therein the latest setting condition of the volume change rate set here.

Next, the step detecting unit 20 detects a current setting of a sound-volume control step, and provides the current setting as sound-volume control step information to the determining-and-controlling unit 12 (step 16). The determining-and-controlling unit 12 controls sound volume based on the sound-volume control step information provided from the step detecting unit 20 and a current setting condition of a volume change rate present in the storage unit 14, creates an output sound signal, and sends the output sound signal to the sound output device in the audio device. Thus, sound is output (step 17). Subsequently, the determining-and-controlling unit 12 determines whether sound volume control is operated by a user, i.e., a sound-volume control step is operated by the user (step 18). If there is no operation for sound volume control (No at step 18), the flow is ended. In contrast, if there is an operation for sound volume control (Yes at step 18), the process returns to step 16 again to be continued. According to the process described above, sound volume is controlled by the sound-volume controller 1.

Although the above embodiment is described on the assumption that a sound-volume controller has 12 steps for controlling sound volume, and controls sound output volume from 0 dB to 120 dB by using the 12 steps, the number of steps and the levels of sound volume are not so limited in the present invention. Any number of steps and any levels of sound volume can be taken as desired. The same is applied to the following embodiments. In the above description, it is also assumed that the volume change rate in the zone M is set smaller; however, undoubtedly, the volume change rate in the zone L or the zone H can be set smaller. In addition, although the above embodiment is explained on the assumption that the number of steps in the zone L, the zone M, and the zone H is the same, the number of steps in each zone does not have to be equal, and can vary as desired.

### [Second Embodiment]

In the first embodiment described above, the entire step zone is divided into three step zones, namely, the zone L, the zone M, and the zone H. The example is explained as to the case where the entire step zone is divided into four step zones. Configuration of a sound-volume controller is similar to that in the first embodiment, and detailed explanation is omitted.

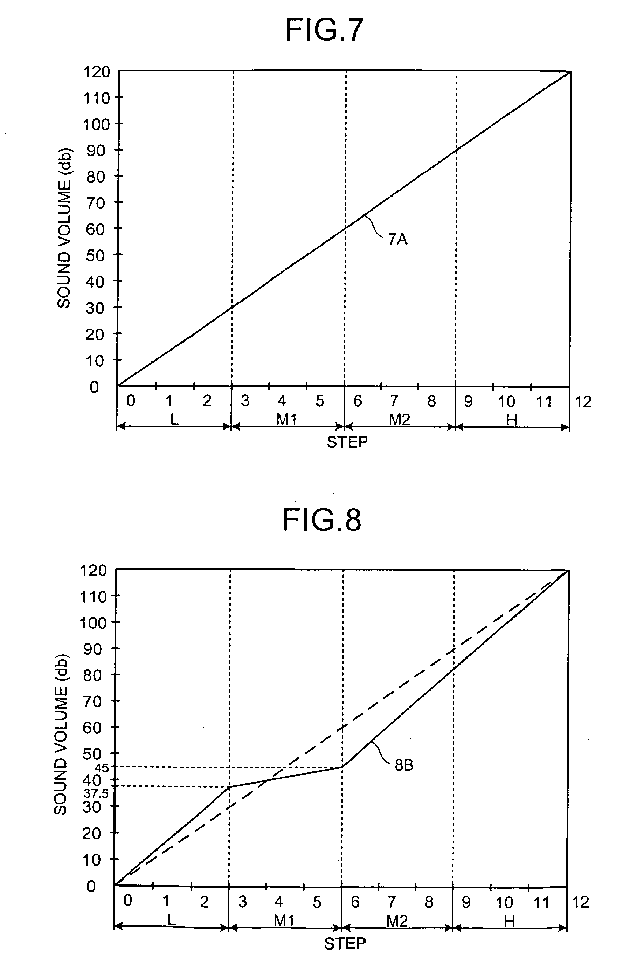

In the sound-volume controller according to this embodiment, when an audio device is turned on, a volume change rate in the sound-volume controller is set at a volume change rate having a characteristic indicated by a characteristic curve 7A in Fig. 7. Precisely, the volume change rate per step is uniformly set over the entire step zone at 10 dB/step. Accordingly, when sound output volume is controlled based on this setting, the sound output volume increases or decreases by 10 dB as a level of a step is raised or lowered by one.

In the sound-volume controller according to this embodiment, the entire step zone is divided into four step zones, namely, a zone L between step 0 and step 3, a zone M1 between step 3 and step 6, a zone M2 between step 6 and step 9, and a zone H between step 9 and step 12, as shown in Fig. 7.

The sound-volume controller selects any one of the four step zones, and can set a volume change rate in selected step zone smaller than and different from a volume change rate in the other step zones. For example, as shown with a characteristic curve 8B in Fig. 8, a volume change rate in the zone M1, i.e., a step zone between step 3 and step 6, can be set smaller. In the example shown in Fig. 8, the volume change rate in the zone M1 is set at 2.5 dB/step. In this case, in the zone M1, sound volume from 37.5 dB to 45 dB is controlled by using three steps from step 3 to step 6. According to the setting of the volume change rate shown in Fig. 7 (the characteristic curve 7A), as described above, the volume change rate is 10 dB/step. Accordingly, by lowering the volume change rate in the zone M1 to 2.5 dB/step as shown with the characteristic curve 8B in Fig. 8, the sound-volume controller can achieve a fine adjustment of sound volume in the zone M1 compared to when the volume change rate is set as shown in Fig. 7 (the characteristic curve 7A). In other words, the sound-volume controller can control sound volume finely and more accurately as desired by a user by using the step zones effectively.

On the other hand, in the zones L, M2, and H, a volume change rate is uniformly set to control sound volume in a range from 0 dB to 37.5 dB, and a range from 45 dB to 120 dB, with the remaining steps. Precisely, to control sound volume in the remaining ranges (the range from 0 dB to 37.5 dB, and the range from 45 dB to 120 dB) with remaining nine steps (steps other than the three steps from step 3 to step 6), the volume change rate in the zones L, M2, and H is set larger than the volume change rate shown in Fig. 7 (the characteristic curve 7A). As shown in Fig. 8, the volume change rate in the zones L, M2, and H in this case is 12.5 dB/step.

Because the volume change rate in the zone L is set larger than the volume change rate shown in Fig. 7 (the characteristic curve 7A), a time needed for sound output volume to reach sound volume in the zone M1 from 0 dB is reduced. For example, to reach 30 dB of sound volume, a time corresponding to three steps is required by the setting of the volume change rate shown in Fig. 7. In contrast, with the setting of the volume change rates shown in Fig. 8 (the characteristic curve 8B), sound volume reaches 30 dB during a time corresponding to 2.4 steps (although actual operation is carried out for each step, time to reach 30 dB is faster than that in the setting of the volume change rate shown in Fig 7). This can reduces a waiting time to reach desired sound volume, so that a user can control sound volume more comfortably.

In the above description, it is assumed that the volume change rate in the zone M1 is set smaller; however, undoubtedly, a volume change rate in the zone L, the zone M2, or the zone H can be set smaller. In addition, although it is also assumed that the number of steps in the zone L, the zone M2, and the zone H is the same, the number of steps in each zone does not have to be equal, and can vary as desired.

### [Third Embodiment]

In the first and second embodiments described above, the entire step zone is divided into a plurality of step zones, and a volume change rate is changed in a specific step zone selected from those step zones. The example is explained as to the case where a step zone in which a volume change rate is to be changed is selected by specifying a specific step. Configuration of a sound-volume controller is similar to that in the first embodiment, and detailed explanation is omitted.

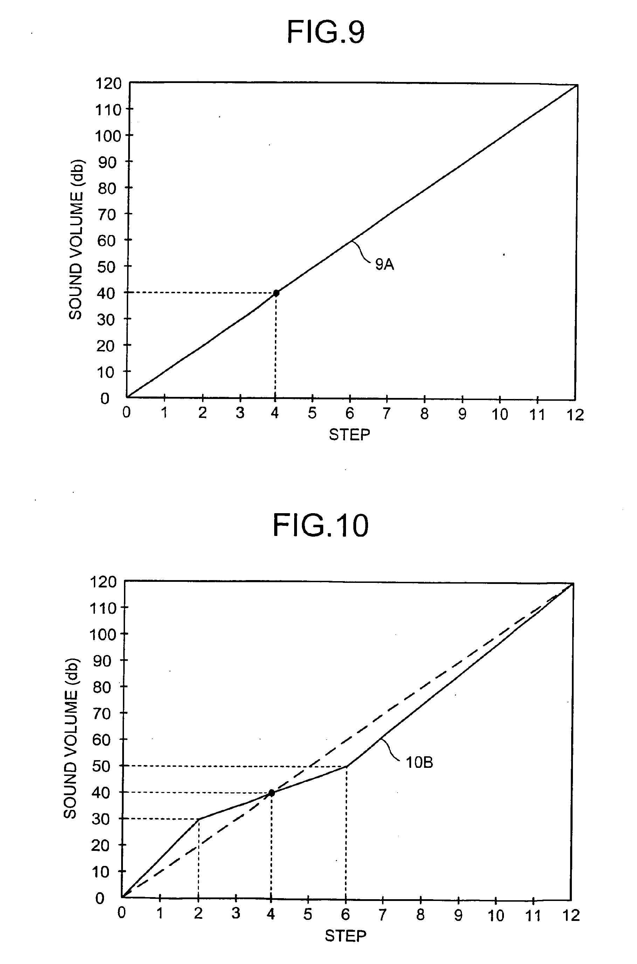

In the sound-volume controller according to this embodiment, when an audio device is turned on, a volume change rate in the sound-volume controller is set at a volume change rate having a characteristic indicated by a characteristic curve 9A in Fig. 9. Precisely, the volume change rate per step is uniformly set over the entire step zone at 10 dB/step. Accordingly, when sound output volume is controlled based on this setting, the sound output volume increases or decreases by 10 dB as a level of a step is raised or lowered by one.

In the sound-volume controller according to this embodiment, a specific step is specified to select a step zone in which a volume change rate is to be changed. If the user wants to make a fine adjustment of sound volume in a relatively small volume range, for example, when listening to music in a room quietly, the user specifies step 4 as shown in Fig. 9. The sound-volume controller can set a volume change rate smaller in a step zone including step 4 and two each of lower and upper steps adjacent thereto differently from volume change rates in the other step zones. Precisely, the sound-volume controller can set the volume change rate in a step zone between step 2 and step 6 smaller as shown with a characteristic curve 10B in Fig. 10 by specifying step 4.

On the characteristic curve 10B in Fig.10, the volume change rate in the step zone between step 2 and step 6 is set at 5 dB/step. In this case, sound volume from 30 dB to 50 dB is controlled by using four steps from step 2 to step 6. According to the setting of the volume change rate shown in Fig. 9 (the characteristic curve 9A), as described above, the volume change rate is 10 dB/step. Accordingly, by lowering the volume change rate in the step zone between step 2 and step 6 to 5 dB/step as shown with the characteristic curve 10B in Fig. 10, the sound-volume controller can achieve a fine adjustment of sound volume in this zone compared to when the volume change rate is set as shown in Fig. 9 (the characteristic curve 9A). In other words, the sound-volume controller can control sound volume finely and more accurately as desired by a user by using the step zones effectively.

In the remaining step zones, namely, a step zone between step 0 and step 2, and a step zone between step 6 and step 12, a volume change rate is set larger than the volume change rate shown in Fig. 9 (the characteristic curve 9A). In this embodiment, for setting a volume change rate in these step zones, volume change rates set in the remaining step zones are not uniform; a volume change rate in the step zone between step 0 and step 2 is set larger than a volume change rate in the step zone between step 6 and step 12. In this embodiment, as shown with the characteristic curve 10B in Fig. 10, the volume change rate in the step zone between step 0 and step 2 is set at 15 dB/step, while the volume change rate in the step zone between step 6 and step 12 is set at 11.7 dB/step.

Because the volume change rate in the step zone between step 0 and step 2 is set larger than the volume change rate shown in Fig. 9 (the characteristic curve 9A), a time needed for sound output volume to reach 30 dB from 0 dB is reduced. For example, to reach 30 dB of sound volume, a time corresponding to three steps is required by the setting of the volume change rate indicated by the characteristic curve 9A in Fig. 9. In contrast, with the setting of the volume change rates indicated by the characteristic curve 10B in Fig. 10, sound volume reaches 30 dB during a time corresponding to two steps. Moreover, in this embodiment, the volume change rate in the step zone between step 0 and step 2 is set larger than the volume change rate in the step zone between step 6 and step 12, and therefore, the above effect can be obtained more effectively than when the same volume change rate is set in the remaining step zones. This can reduces a waiting time to reach desired sound volume, so that a user can control sound volume more comfortably.

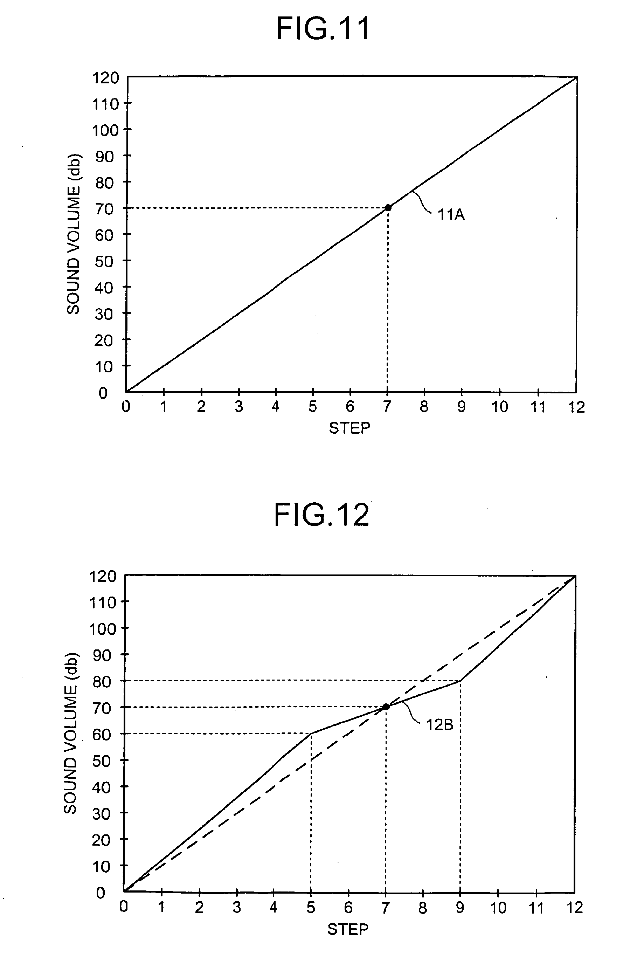

If the user wants to make a fine adjustment of sound volume in a relatively large volume range, for example, when playing music in a public place such as in a shopping centre, the user specifies, for example, step 7 as shown in Fig. 11. The sound-volume controller can set a volume change rate smaller in a step zone including step 7 and two each of lower and upper steps adjacent thereto differently from volume change rates in the other step zones. Precisely, the sound-volume controller can set the volume change rate in a step zone between step 5 and step 9 smaller as shown with a characteristic curve 12B in Fig. 12 by specifying step 7.

Also in this case, a volume change rate when an audio device is turned on is set at a volume change rate having a characteristic indicated by a characteristic curve 11A in Fig. 11, and the volume change rate per step is uniformly set over the entire step zone. The volume change rate is 10 dB/step. Accordingly, when sound output volume is controlled based on this setting, the sound output volume increases or decreases by 10 dB as a level of a step is raised or lowered by one.

In the example of the setting of the volume change rate indicated by the characteristic curve 12B in Fig.12, the volume change rate in the step zone between step 5 and step 9 is set at 5 dB/step. In this case, sound volume from 60 dB to 80 dB is controlled by using four steps from step 5 to step 9. According to the setting of the volume change rate indicated by the characteristic curve 11A in Fig. 11, as described above, the volume change rate is 10 dB/step. Accordingly, by lowering the volume change rate in the step zone between step 5 and step 9 to 5 dB/step as shown with the characteristic curve 12B in Fig. 12, the sound-volume controller can achieve a fine adjustment of sound volume in this zone compared to when the volume change rate is set as shown with the characteristic curve 11A in Fig. 11. In other words, the sound-volume controller can control sound volume finely and more accurately as desired by a user by using the step zones effectively.

In the remaining step zones, namely, a step zone between step 0 and step 5, and a step zone between step 9 and step 12, a volume change rate is set larger than the volume change rate indicated by the characteristic curve 11A in Fig. 11. In this embodiment, as shown with the characteristic curve 12B in Fig. 12, the volume change rate in the step zone between step 0 and step 5 is set at 12 dB/step, while the volume change rate in the step zone between step 9 and step 12 is set at 13.3 dB/step.

Because the volume change rate in the step zone between step 0 and step 5 is set larger than the volume change rate indicated by the characteristic curve 11A in Fig. 11, a time needed for sound output volume to reach 60 dB from 0 dB is reduced. For example, to reach 60 dB of sound volume, a time corresponding to six steps is required by the setting of the volume change rate indicated by the characteristic curve 11A in Fig. 11. In contrast, with the setting of the volume change rates indicated by the characteristic curve 12B in Fig. 12, sound volume reaches 60 dB during a time corresponding to five steps. This can reduces a waiting time to reach desired sound volume, so that a user can control sound volume more comfortably.

In the above description, step 4 and step 7 are specified to select a step zone in which a volume change rate is to be changed. However, those steps are cited merely by way of example and without limitation, and, in the present invention, any step can be specified. Additionally, the volume change rate is changed in the step zone including a specified step and two each of upper and lower steps adjacent thereto. In the present invention, however, a step zone in which a volume change rate is to be changed is not necessarily determined in this manner. That is, a volume change rate can be changed in a step zone arbitrarily determined based on a specified step. For example, a volume change rate can be changed in a zone including a specified step as the center and one each or three each of upper and lower steps adjacent thereto. A volume change rate can also be changed in a zone between the specified step and one adjacent lower step, or a zone between the specified step and two adjacent upper steps.

### [Fourth Embodiment]

In the first to third embodiments described above, a fine adjustment of sound volume is performed by lowering a volume change rate in a specific step zone in the entire step zone. The example is explained as to the case where a volume change rate in the entire step zone is changed.

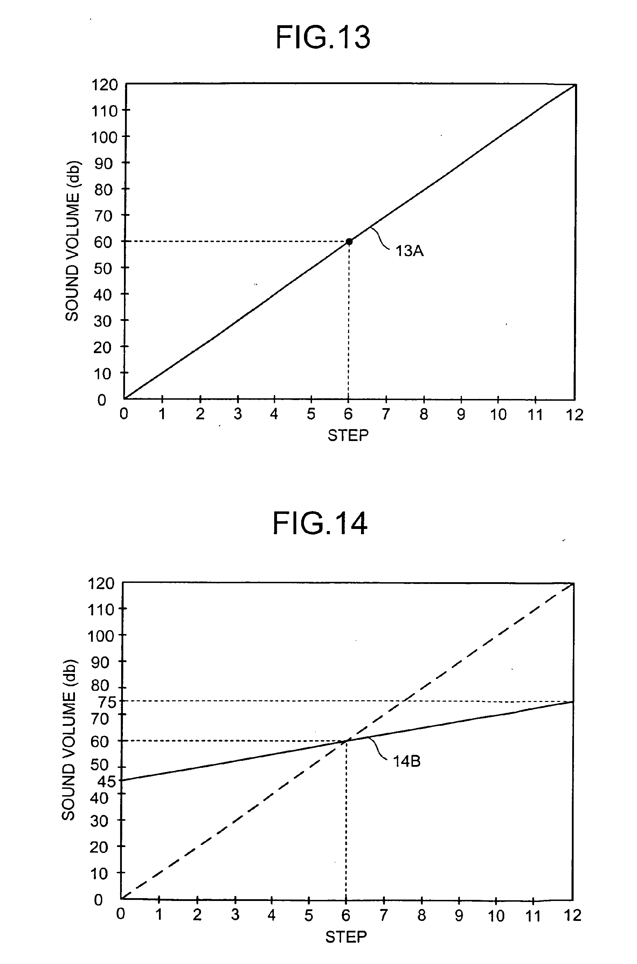

In a sound-volume controller according to this embodiment, when an audio device is turned on, a volume change rate in the sound-volume controller is set at a volume change rate having a characteristic indicated by a characteristic curve 13A in Fig. 13. Precisely, the volume change rate per step is uniformly set over the entire step zone at 10 dB/step. Accordingly, when sound output volume is controlled based on this setting, the sound output volume increases or decreases by 10 dB as a level of a step is raised or lowered by one.

The sound-volume controller according to this embodiment controls a fine adjustment of sound volume by shifting to a fine adjustment mode at a certain step. The fine adjustment mode is a mode in which a fine adjustment of sound volume is controlled by lowering a volume change rate in the entire step zone. Precisely, at the time a user specifies a certain step, the volume change rate is set at a low level in the entire step zone to perform a fine adjustment of sound volume in a predetermined range with sound volume corresponding to specified step as the center. For example, if there is a shift to the fine adjustment mode at step 6 as shown with a characteristic curve 14B in Fig. 14, the volume change rate in the entire step zone is set smaller based on step 6 to perform a fine adjustment of sound volume. In an example shown in the characteristic curve 14B in Fig. 14, the volume change rate in the entire step zone is set at 2.5 dB/step.

In this case, after shifting to the fine adjustment mode, the sound-volume controller controls a fine adjustment of sound volume in a range from 47.5 dB to 75 dB using all steps 1 to 12. As described above, with the setting of the volume change rate indicated by the characteristic curve 13A in Fig. 13, the volume change rate is 10 dB/step. Therefore, by setting a smaller volume change rate, 2.5 dB/step, in the entire step zone as shown in the characteristic curve 14B in Fig. 14, after shifting to the fine adjustment mode, the sound-volume controller can achieve a finer adjustment of sound volume than when the volume change rate is set as indicated by the characteristic curve 13A in Fig. 13. In other words, the sound-volume controller can control sound volume finely and more accurately as desired by a user by using all the step zones effectively.

A shift to the fine adjustment mode can be activated, for example, by an instruction to change to the fine adjustment mode input by a user. For another example, a shift to the fine adjustment mode can be performed automatically at the time a user stops operation for sound volume control, i.e., at the time a user's operation of inputting a sound volume step stops, or after a certain time from such moment.

### [Fifth Embodiment]

In the fourth embodiment described above, a volume change rate in the entire step zone is changed in the fine adjustment mode. The example is explained as to the case where a fine adjustment mode and a rough adjustment mode are employed.

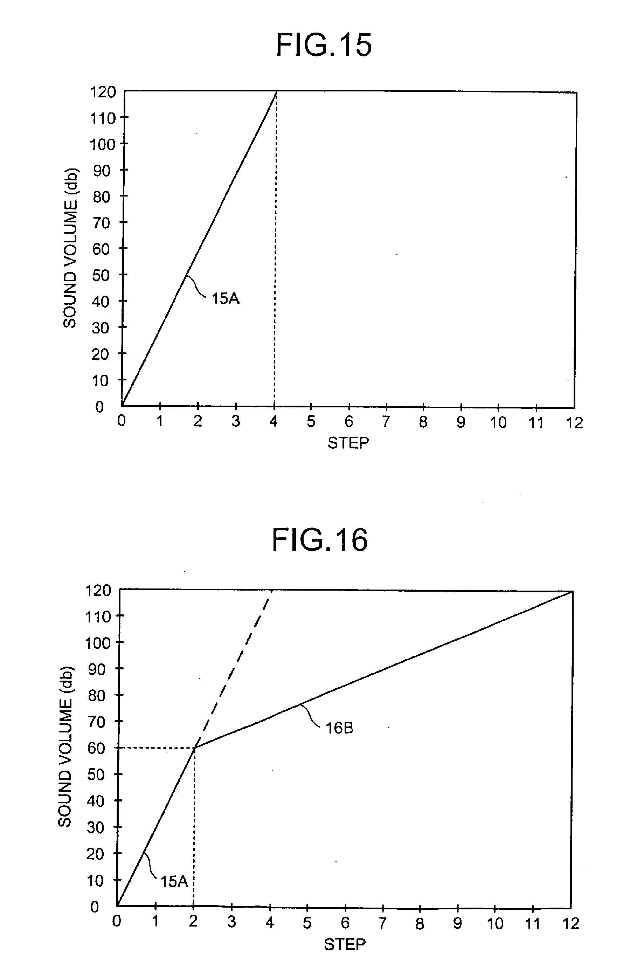

In a sound-volume controller according to this embodiment, when an audio device is turned on, a volume change rate in the sound-volume controller is set in a rough adjustment mode as shown with a characteristic curve 15A in Fig. 15. Here, the rough adjustment mode is a mode in which a rough adjustment of sound volume is controlled by setting a large volume change rate in a certain step zone. At this moment, a volume change rate per step is uniformly set at 30 dB/step. Accordingly, when sound output volume is controlled based on this setting, the sound output volume increases or decreases by 30 dB as a level of a step is raised or lowered by one.

The sound-volume controller according to this embodiment controls a fine adjustment of sound volume by specifying a step while shifting to a fine adjustment mode at upper steps from specified step. The fine adjustment mode is a mode in which a fine adjustment of sound volume is controlled by lowering a volume change rate in a whole step zone as in the fourth embodiment. Precisely, in a step zone including steps upper from the specified step, the volume change rate in the step zone is lowered to perform a fine adjustment of sound volume.

For example, as shown with a characteristic curve 16B in Fig. 16, if step 2 is specified to make a shift to the fine adjustment mode, the volume change rate in a step zone including the upper steps from step 2 (sound volume range above 60 dB) is set smaller. In an example shown with the characteristic curve 16B in Fig. 16, a volume change rate in a step zone between step 2 and step 12 is set at 6 dB/step.

In this case, sound volume in a range from 0 dB to 60 dB is roughly controlled by using two steps from step 0 to step 2. Besides, sound volume in a range from 60 dB to 120 dB is finely controlled by using ten steps from step 2 to step 12.

Thus, the volume change rate is set larger in the step zone between step 0 and step 2 to control sound volume roughly, so that a time needed for sound output volume to reach 60 dB from 0 dB is reduced. For example, to reach 60 dB of sound volume, a time corresponding to six steps is required by the setting of the volume change rate indicated by the characteristic curve 13A in Fig. 13 according to the fourth embodiment. In contrast, with the setting of the volume change rates indicated by the characteristic curve 16B in Fig. 16, sound volume reaches 60 dB during a time corresponding to two steps. This can reduces a waiting time to reach desired sound volume, so that a user can control sound volume more comfortably.

Moreover, by lowering the volume change rate in the step zone between step 2 and step 12 to achieve a fine adjustment of sound volume, sound volume can be controlled more finely than when the volume change rate is set as indicated by the characteristic curve 13A in Fig. 13 according to the fourth embodiment. Thus, the sound-volume controller can control sound volume smoothly, finely, and more accurately as desired by a user by using the entire step zone.

In the above description, the volume change rate in the sound-volume controller is set in the rough adjustment mode when the audio device is turned on. However, according to the present invention, a shift to the rough adjustment mode can be performed based on a user's input for switching to a predetermined rough adjustment mode after the user turns on the audio device.

A shift to the fine adjustment mode can be activated, for example, by an instruction to change to the fine adjustment mode input by a user. For another example, a shift to the fine adjustment mode can be performed automatically at the time a user stops operation for sound volume control in the rough adjustment mode, i.e., at the time a user's operation of inputting a sound volume step stops, or after a certain time from such moment.

The process of the sound volume control as explained in the above embodiments can be implemented by a computer program, a sound-volume controlling computer program, which is executed to perform the process. Fig. 17 is a block diagram of relevant part of hardware (computer) used for controlling sound volume according to the present invention with the sound-volume controlling computer program. The computer that executes the sound-volume controlling computer program includes a read-only memory (ROM) 102 that stores therein a computer program to perform the process for sound volume control, etc., a central processing unit (CPU) 101 that executes the process for sound volume control according to the computer program in the ROM 102, a random access memory (RAM) 103 in which a work area is created and various data needed for controlling sound volume adjustment is stored, and a bus 104 that connects the respective units.

## Claims

1. A sound-volume controlling method of controlling sound volume per step, the sound-volume controlling method comprising:
a changing step for changing a volume change amount per step; and
a controlling step for controlling sound volume based on changed volume change amount per step.

2. A sound-volume controlling method of controlling sound volume per step, the sound-volume controlling method comprising:
a zone specifying step for specifying a step zone in which a volume change amount per step is to be changed;
a changing step for changing a volume change amount per step in specified step zone; and
a controlling step for controlling sound volume based on changed volume change amount per step.

3. The sound-volume controlling method according to claim 2, wherein the changing step includes changing the volume change amount per step in the specified step zone smaller than any volume change amount per step in other than the specified step zone.

4. The sound-volume controlling method according to claim 2, wherein the changing step includes changing any volume change amount per step in other than the specified step zone to a same rate.

5. The sound-volume controlling method according to claim 2, wherein the changing step includes changing a volume change amount per step in other than the specified step zone differently in accordance with a step zone.

6. The sound-volume controlling method according to claim 2, wherein
the zone specifying step includes specifying a total step zone; and
the changing step includes changing a volume change amount per step in the total step zone.

7. A sound-volume controller that controls sound volume per step, the sound-volume controller comprising:
a changing unit that changes a volume change amount per step; and
a controlling unit that controls sound volume based on changed volume change amount per step.

8. A sound-volume controller that controls sound volume per step, the sound-volume controller comprising:
a zone specifying unit that specifies a step zone in which a volume change amount per step is to be changed;
a changing unit that changes a volume change amount per step in specified step zone; and
a controlling unit that controls sound volume based on changed volume change amount per step.

9. The sound-volume controller according to any one of claims 7 and 8, further comprising a storage unit that stores therein a pattern of the volume change amount per step, wherein
the changing unit changes the volume change amount per step based on the pattern present in the storage unit

10. Electronic equipment comprising the sound-volume controller according to any one of claims 7 to 9.

11. A computer program for controlling sound volume that causes a computer to execute a method of controlling sound volume per step, the computer program causing the computer to execute:
a changing step for changing a volume change amount per step; and
a controlling step for controlling sound volume based on changed volume change amount per step.

12. A computer program of controlling sound volume that causes a computer to execute a method of controlling sound volume per step, the computer program causing the computer to execute:
a zone specifying step for specifying a step zone in which a volume change amount per step is to be changed;
a changing step for changing a volume change amount per step in specified step zone; and
a controlling step for controlling sound volume based on changed volume change amount per step.
